# EUROPÄISCHE PATENTSCHRIFT

(11) **EP 2 609 803 B1**
(45) Veröffentlichungstag und Bekanntmachung des Hinweises auf die Patenterteilung: **07.03.2018**
(21) Anmeldenummer: 11749374.2
(22) Anmeldetag: 03.08.2011
(51) Int. Cl.: H05K 9/00, H05K 5/04, H05K 7/14

(54) **KASTENGEHÄUSE UND HERSTELLUNGSVERFAHREN**
BOX ENCLOSURE AND METHOD FOR PRODUCING SAME
COFFRET ET PROCÉDÉ DE FABRICATION

(30) Priorität: 26.10.2010 DE 102010049605; 23.08.2010 DE 102010035100
(43) Veröffentlichungstag der Anmeldung: 03.07.2013
(60) Teilanmeldung: 13187075.0
(73) Patentinhaber: Rohde & Schwarz GmbH & Co. KG, 81671 München (DE)
(72) Erfinder: MUHR, Hermann, 94267 Prackenbach (DE); FISCHL, Andreas, 94244 Geiersthal (DE); KUFER, Wolfgang, 84453 Mühldorf (DE); KÖNIG, Hans-Dieter, 85540 Haar (DE); HINGRAINER, Helmut, 83064 Raubling (DE)
(74) Vertreter: Körfer, Thomas
(86) Internationale Anmeldenummer: PCT/EP2011/063367
(87) Internationale Veröffentlichungsnummer: WO 2012/025352

(56) Entgegenhaltungen:
- EP-A1- 1 463 399
- EP-A2- 1 765 049
- DE-A1- 19 545 448
- DE-U1- 29 618 628
- US-A- 5 398 833
- US-A1- 2004 246 693

## Beschreibung

Die Erfindung bezieht sich auf ein Kastengehäuse zum Einbau von elektronischen Baugruppen mit einer Unterteilung in Teilbereiche und ein Verfahren zu dessen Herstellung.

Das Dokument DE 196 03 368 A1 beschreibt ein Kastengehäuse für elektronische Messgeräte von derzeit üblicher Bauart. Das beschriebene Kastengehäuse besteht aus einem geschlossenen rechteckigen Rahmen, einer Montagewanne mit einem flachen Boden und davon rechtwinklig abstehenden schmalen Seitenwänden, die die Bedienelemente des Geräts aufnehmen, sowie einer Fronthaube, die über die Montagewanne gestülpt wird und die Frontseite des Kastengehäuses bildet. Rückseitig ist auf den Rahmen ein Baugruppenträger angesetzt, der aus Blechteilen zu einem auf mindestens einer Seite offenen Kasten zusammengesetzt ist und in dem die einzelnen Baugruppen eingesetzt werden. Auf den Baugruppenträger ist von hinten ein Gehäusetubus aufschiebbar, der vorne und hinten offen ist und aus Blech durch Biegen hergestellt ist. Zur hochfrequenzdichten Abschirmung ist eine umlaufende Ringnut an einem Kontaktsteg ausgebildet, in die eine Metallgeflechtschnur eingesetzt werden kann.

Nachteilig an dem beschriebenen Kastengehäuse ist der hohe Platzbedarf zum Abziehen des Gehäusetubusses und somit die schlechte Zugänglichkeit, insbesondere wenn das Gehäuse bereits in ein Rack eingebaut ist. Ein z. B. auf Teleskopschienen montiertes Gehäuse muss von den Teleskopschienen gelöst werden, um den Gehäusetubus abziehen zu können. Elektronische Baugruppen werden somit meist von der Geräterückseite aus in Richtung Frontplatte eingebaut, um dieses umständliche Öffnen des Gehäuses beim Wechsel von Baugruppen zu vermeiden. Außerdem wäre es wünschenswert innerhalb des Gehäuses Teilbereiche, die durch Trennwände begrenzt sind, auszubilden und so Baugruppen von unterschiedlichem Typ getrennt gruppieren zu können. Das Dokument US 2004/246693 A1 betrifft ein Schirmungsgehäuse für ein elektronisches Modul mit Boden, Rückwand, Abdeckung mit Seitenwänden, sowie Trennwänden. Alle Komponenten sind elektrisch leitfähig sowie mechanisch und elektrisch miteinander verbunden. So verfügen die Seiten- und Trennwände über eine Vielzahl von Steckvorsprüngen zum Eingriff in entsprechende Schlitze in Boden oder Oberseite der Abdeckung.

Das Dokument DE 195 45 448 A1 offenbart ein Stromrichter-Multifunktionsgehäuse für ein Fahrzeug, wobei die Geräteaußenwände größtenteils als Hohlprofilwände ausgebildet sind, in denen abwechselnd eine Vielzahl von Wasserkanälen und stark verrippten Luftkanälen verlaufen.

Das Dokument EP 1 463 399 A1 offenbart ein Gehäuse einer elektronischen Vorrichtung, bei dem eine Deckplatte bzw. eine Bodenplatte in Aufnahmeöffnungen in den Seitenwänden des Gehäuses lösbar durch Einschieben befestigt sind, wobei die Seitenwänden einen Stirnfalz mit zueinander geneigten Schenkeln aufweisen und im einen Schenkel Aufnahmeöffnungen für die Deck- bzw. Bodenplatte ausgebildet sind.

Die Dokumenten US 5 398 833 A und DE 296 18 628 U1 offenbaren unter anderem die Anwendung eines Federbandes eingebracht bzw. lösbar verbunden mit einem Stirnfalz zur besseren elektrischen Kontaktierung zwischen den Wänden bzw. Platten eines Kastengehäuses zum Einbau von elektronischen Baugruppen.

Es ist daher die Aufgabe der vorliegenden Erfindung ein Gehäuse für elektronische Baugruppen mit verschiedenen Unterteilungen in Teilbereiche und ein entsprechendes Herstellungsverfahren zu schaffen, das einfach und kostengünstig herstellbar ist, sowie für die Bestückung und Wartung einfach zugänglich ist.

Die Aufgabe wird durch das erfindungsgemäße Kastengehäuse gemäß Anspruch 1 sowie durch ein Verfahren zur Herstellung eines Kastengehäuses gemäß Anspruch 15 gelöst. In den Unteransprüchen sind vorteilhafte Weiterbildungen des erfindungsgemäßen Kastengehäuses bzw.
Herstellungsverfahrens dargestellt.

Das erfindungsgemäße Kastengehäuse zum Einbau von elektronischen Baugruppen hat Rahmenelemente und Seitenwände und weist eine Unterteilung in Teilbereiche auf, die durch Trennwände begrenzt sind, wobei die Rahmenelemente sowie die Seiten- und Trennwände mindestens eine Ausnehmung und/oder mindestens einen randseitigen Überstand aufweisen, ein Überstand in eine Ausnehmung eingreift und der Überstand und die Ausnehmung durch Schweißen miteinander verbunden sind. Vorteilhafterweise können durch die Platzierung der Ausnehmungen und der entsprechenden randseitigen Überstände unterschiedlichste Unterteilungen des Kastengehäuses erzielt werden. Die einzelnen Seiten- und Trennwände sind einfach zusammensteckbar und bilden bereits vor dem Schweißvorgang ein stabiles Gebilde. Dies vereinfacht das Einspannen der Einzelteile zur Vorbereitung für den darauffolgenden Schweißvorgang. Daraus ergibt sich eine kurze Vorspannzeit und somit eine zeitoptimierte Montage.

Vorteilhafterweise weist ein Zwischenraum zwischen dem Überstand und einem Rand der Ausnehmung, in die der

Überstand eingreift, eine Breite von weniger als 100 µm, bevorzugt weniger als 50 µm Breite auf. Die daraus resultierenden Toleranzen für die Größe des Überstands sowie der Ausnehmungen sind mit der derzeit üblichen Stanz- oder Laserschneidtechnik ohne weiteres erreichbar. Somit kann zur Fertigung des Kastengehäuses die übliche Stanz- oder Schneidetechniken eingesetzt werden und erlaubt eine kostengünstige Herstellung. Erfindungsgemäß sind die Deckenplatte und die Bodenplatte durch Einschieben in Aufnahmeöffnungen in den Seitenwänden lösbar befestigt. Die Seiten- und/oder Trennwand weist einen Stirnfalz mit einem ersten und zweiten zueinander geneigten Schenkel auf, wobei im ersten Schenkel Aufnahmeöffnungen für die Deck- bzw. Bodenplatte vorgesehen sind. Somit kann Deck- und Bodenplatte separat vom Kastengehäuse nach oben oder unten abgenommen werden. Das Gehäuse kann dabei z. B. auf Teleskopschienen montiert in einem Rack verbleiben. Außerdem sind keine Werkzeuge, z. B. Schraubendreher etc., zum Lösen der Deck- oder Bodenplatte notwendig, so dass lediglich ein geringer freier Raum zum Öffnen des Kastengehäuses notwendig ist. Von Vorteil ist auch, dass eine Seiten- und/oder eine Trennwand eine Mehrzahl von Führungsöffnungen mit überstehenden Kragen aufweist, wobei die Führungsöffnungen auf zwei parallelen Geraden in einem Abstand voneinander parallel zur Einschubrichtung einer elektronischen Baugruppe an der Seiten- oder Trennwand angeordnet sind. Somit können elektronische Baugruppen entlang der überstehenden Kragen geführt zu ihrem Steckplatz geführt werden. Zusätzlich gewährleisten die Führungsöffnungen eine gute Belüftung auch der hinter einer Trennwand liegenden Baugruppe und somit einen durchgängigen Luftstrom durch die verschiedenen Teilbereiche des Gehäuses hindurch.

Vorteilhafterweise weist der Kragen einer Führungsöffnung eine runde Kontur auf. Dies ermöglicht ein leichtes und beschädigungsfreies Einführen einer Baugruppe, insbesondere der Platine einer Baugruppe. Erfindungsgemäß ist mindestens ein Federelement lösbar mit einer Seiten- und/oder Trennwand verbunden und so angeordnet, dass es in den durch die beabstandeten Führungsöffnungen begrenzten Bereich einhakt. Insbesondere wird das Federelement in eine Ausnehmung der Seiten- und/oder Trennwand eingeschoben. Somit kann die Position des Federelements in den durch die beabstandeten Führungsöffnungen begrenzten Bereich variabel eingestellt werden und eine Baugruppe bzw. die in ihr enthaltene Platine in der Höhe so gehalten werden, dass der Anschluss der Baugruppe exakt in den dafür vorgesehenen Stecker eingeführt wird. Somit kann der Abstand zwischen den durch die Führungsöffnungen begrenzten Bereich weiter gewählt werden, so dass Baugruppen mit unterschiedlich dicken Platinen einführbar sind und dennoch der Stecker beim Einsetzen der Baugruppe exakt getroffen wird. Somit werden Stecker und Baugruppe mechanisch wenig belastet und die Lebensdauer der Baugruppe positiv beeinflusst. Vorteilhafterweise ist mindestens eine Zentriernase im Randbereich der Seiten- und/oder Trennwand angeordnet, in die eine Ausnehmung in einem Baugruppengehäuse eingreift. Somit wird eine Ausrichtung der Baugruppe an der dem Stecker gegenüberliegenden Seite der Baugruppe erreicht und ein Bewegungsspiel der Baugruppe minimiert.

Es ist weiterhin von Vorteil, in einem ersten Teilbereich des Kastengehäuses eine erste Baugruppe oder mehrere erste Baugruppen senkrecht zur Ebene der Seitenwand einzubauen und in einem zweiten Teilbereich eine zweite Baugruppe oder mehrere zweite Baugruppen senkrecht zur Seitenwand und senkrecht zur ersten Baugruppe im ersten Teilbereich einzubauen. Dies ermöglicht eine Gruppierung ähnlicher Baugruppentypen, z. B. Hochfrequenz- oder digitale Schaltungsbaugruppen, in einem Teilbereich des Gehäuses. Vorkehrungen zur elektromagnetischen Abschirmung oder zur Anbindung an Datenverbindungen können somit effektiv auf die Bedürfnisse des Baugruppentyps in einem Teilbereich angepasst werden. Dabei können gezielt Trennwände zur elektromagnetischen Abschirmung der Baugruppentypen voneinander angebracht werden. Dies reicht in den meisten Fällen aus, insbesondere wenn z.B. jede Hochfrequenzbaugruppe bereits von einem hochfrequenzdichten Chassis umgeben ist.

Es ist außerdem vorteilhaft, wenn eine erste Baugruppe oder mehrere erste Baugruppen in ein erstes Grundrechnermodul eingesteckt sind, die eine zweite Baugruppe oder mehrere zweite Baugruppen in ein zweites Grundrechnermodul eingesteckt sind und das erste Grundrechnermodul parallel zur Steckrichtung der zweiten Baugruppe sowie das zweite Grundrechnermodul parallel zur Streckrichtung der ersten Baugruppe angeordnet ist. Vorteilhaft ist weiterhin, dass das erste Grundrechnermodul und das zweite Grundrechnermodul durch eine Steckverbindung miteinander verbunden sind.

Diese Anordnung der Grundrechnermodule und der darin eingesteckten Baugruppen weist jeweils senkrecht zur Seitenwand liegende Freiräume zwischen den Baugruppen auf und ermöglicht somit eine effektive Belüftung durch einen durchgängigen Luftstrom von einer Seitenwand durch die Zwischenräume zwischen den Baugruppen hindurch zur anderen Seitenwand. Es werden lediglich Steckverbindungen zur Kontaktierung der Baugruppen mit dem jeweiligen Grundrechnermodul sowie zwischen dem ersten und dem zweiten Grundrechnermodul verwendet, so dass die Zwischenräume zwischen den Baugruppen nicht durch Kabel ausgefüllt sind und den Luftstrom behindern. Außerdem bildet die Steckverbindung zwischen den beiden Grundrechnermodul eine platzsparende und effektive Verbindung.

Mit dem erfindungsgemäßen Verfahren zur Herstellung eines Kastengehäuses mit Rahmenelementen und Seitenwänden, das in Teilbereiche unterteilt ist, die durch Trennwände begrenzt sind, wird mindestens eine Ausnehmung und/oder mindestens ein randseitiger Überstand in den Seiten- und Trennwänden eingebracht. Die Seitenwände und Trennwände werden zusammengefügt, indem ein Überstand in eine Ausnehmung eingreift und der Überstand und die Ausnehmung durch Schweißen miteinander verbunden werden.

Es ist insbesondere vorteilhaft, wenn die Seiten- und/oder Trennwände eine oder mehrere Lüftungszonen mit jeweils einer Vielzahl von Lüftungsöffnungen aufweisen und im Bereich der Lüftungszone eine Querprägung quer zu einem Rand der Seiten- und/oder Trennwand in die Seiten- und/oder Trennwand eingebracht wird. Dies verhindert ein Durchbiegen oder Wellen der Seitenwand durch Ausstanzen der Lüftungsöffnungen und fördert die Stabilität des Kastengehäuses.

Es ist ebenfalls vorteilhaft, wenn alle Ausnehmungen, Überstände, Aufnahme-, Führungs- und Lüftungsöffnungen mittels Stanzen und die Führungsnasen mittels Prägen eingebracht werden. Somit sind in einem bzw. zwei Arbeitsgängen alle Führungs- und Befestigungsöffnungen herstellbar. Dies ermöglicht eine kurze Herstellzeit mit gängiger Verfahrenstechnik und ist somit kostengünstig. Unterschiedliche Kastengehäuse-Varianten können einfach durch eine veränderte Positionierung der Ausnehmungen und randseitigen Überstände hergestellt werden.

Ausführungsbeispiele des erfindungsgemäßen Kastengehäuses sind in den Zeichnungen beispielhaft dargestellt und werden anhand der nachfolgenden Beschreibung näher erläutert. Es zeigen:
- Fig. 1: ein Ausführungsbeispiel eines erfindungsgemäßen Kastengehäuses in Explosionsdarstellung;
- Fig. 2: ein Ausführungsbeispiel einer Fronthaube eines erfindungsgemäßen Kastengehäuses in Seitenansicht;
- Fig. 3: ein Ausführungsbeispiel eines Seitenelements eines erfindungsgemäßen Kastengehäuses;
- Fig. 4: ein Ausführungsbeispiel einer erfindungsgemäßes Verbindung zwischen Seiten- und/oder Trennwänden mit einem Rahmenelement in perspektivischer Ansicht;
- Fig. 5: eine vergrößerte Darstellung einer erfindungsgemäßen Verbindung zwischen einer Seiten- und/oder Trennwand und einem Rahmenelement entsprechend Fig.4 in Seitenansicht;
- Fig. 6: eine erfindungsgemäße Verbindung entsprechend Fig. 5 in Draufsicht;
- Fig. 7: ein Ausführungsbeispiel der Verbindung zwischen Deckenplatte und Seitenwand eines erfindungsgemäßen Kastengehäuses in perspektivischer Ansicht;
- Fig. 8: ein erstes Ausführungsbeispiel eines ersten Federbandes eines erfindungsgemäßen Kastengehäuses in perspektivischer Ansicht;
- Fig. 9: ein Ausführungsbeispiel einer Seitenwand mit Federband entsprechend Fig.8 eines erfindungsgemäßen Kastengehäuses;
- Fig. 10: ein zweites Ausführungsbeispiel eines erfindungsgemäßen Federbandes in perspektivischer Ansicht;
- Fig. 11: das zweite Ausführungsbeispiel eines erfindungsgemäßen Federbandes eingebaut in ein Rahmenelement in Seitenansicht;
- Fig. 12: ein drittes Ausführungsbeispiel eines erfindungsgemäßen Federbandes eingebaut in ein Rahmenelement in Seitenansicht;
- Fig. 13: ein Ausführungsbeispiel einer Führungsanordnung für Baugruppen eines erfindungsgemäßen Kastengehäuses in Seitenansicht;
- Fig. 14: eine Baugruppenführungsanordnung entsprechend Fig. 13 in perspektivischer Ansicht;
- Fig. 15: ein erstes Ausführungsbeispiel einer Zentriervorrichtung des erfindungsgemäßen Kastengehäuses in perspektivischer Ansicht;
- Fig. 16: ein zweites Ausführungsbeispiel einer Zentriervorrichtung des erfindungsgemäßen Kastengehäuses in perspektivischer Ansicht;
- Fig. 17: ein Ausführungsbeispiel einer Baugruppenanordnung im erfindungsgemäßen Kastengehäuse in perspektivischer Ansicht und
- Fig. 18: ein Ausführungsbeispiel einer Seiten- oder Trennwand mit Lüftungszone mit Prägestempel in Draufsicht.

Einander entsprechende Teile sind in allen Figuren mit dem gleichen Bezugszeichen versehen.

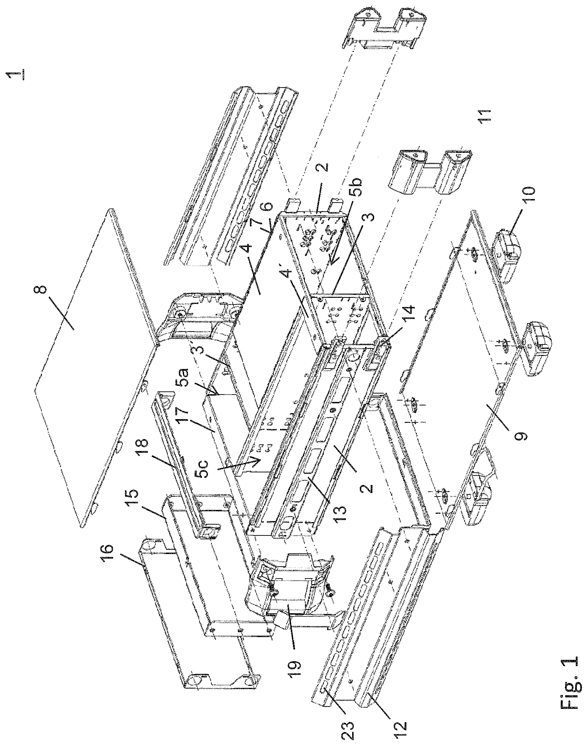

Fig. 1 zeigt einen Überblick über die Komponenten eines erfindungsgemäßen Kastengehäuses 1. Der Grundkörper des Gehäuses besitzt zwei Seitenwänden 2, eine oder mehrere Trennwände 3 sowie Rahmenelemente 4, die als flächige Rahmenelemente 4 oder stegförmige Rahmenelemente 4' oder aber als Frontrahmenelement 17 ausgeprägt sein können. Durch die entweder parallel zur Seitenwand 2 ausgerichteten Trennwände 3 und/oder senkrecht zur Seitenwand 2 ausgerichteten Trennwand 3' entstehen unterschiedliche Teilbereiche 5a, 5b, 5c im Kastengehäuse. Die Seiten- und Trennwände sowie die Rahmenelemente sowie eine Decken- und eine Bodenplatte 8, 9 sind aus einem metallischen Blech, bevorzugt einem Edelstahlblech, gefertigt.

Die Deckenplatte 8 sowie die Bodenplatte 9 schließen den Gehäusegrundkörper ab. Durch eine metallische Verbindung zwischen dieser Decken- und Bodenplatte 8, 9 und zwischen den Seiten- bzw. Trennwänden werden die in die Teilbereiche eingeschobenen Bauelemente zusätzlich elektromagnetisch abgeschirmt. Das Gehäuse selbst muss nur bedingt elektromagnetische Abschirmfunktion aufweisen, da die einzelnen Baugruppen selbst in elektromagnetisch dichten Chassis implementiert sind.

An das Frontrahmenelement 17 anschließend ist über eine Rastschiene 18 eine Montagewanne 15 sowie eine Frontplatte 16 montiert. Die nach außen weisende Oberfläche der beiden Seitenwände 2 weist jeweils eine Befestigungsschiene 13 auf, an der eine Seitenverkleidung 12 und optional daran anschließend seitliche Griffe oder Teleskopschienen montiert werden. Die Seitenverkleidung weist Lüftungsöffnungen 19 auf, um die Zu- bzw. Abfuhr von Luft in das Gehäuse zu Kühlungszwecken zu ermöglichen. An der Seitenverkleidung 12 und/oder dem Frontrahmenelement 17 können Fronttragegriffe 19 befestigt werden.

Am rückseitigen Ende der Seitenwände 2 ist ein weiteres Befestigungselementen 14 angebracht, an dem z.B. ein Rückwandfuß 11 befestigt ist, der als Stoßschutz und als Abstandhalter für die Montage von Anschlüssen und Steckern dient. Ein nicht in einem Rack eingebautes Gerät kann auf diese Rückwandfüße 11 auch abgestellt werden. Zusätzlich können Aufstellfüße 10 an der Bodenplatte 9 des Kastengehäuses angebracht sein, um das Messgerät in einem Rack z.B. auf einen Regalboden aufstellen zu können. Die genannten Füße 9 bzw. 11 müssen zum Öffnen des Gehäuses abmontiert werden.

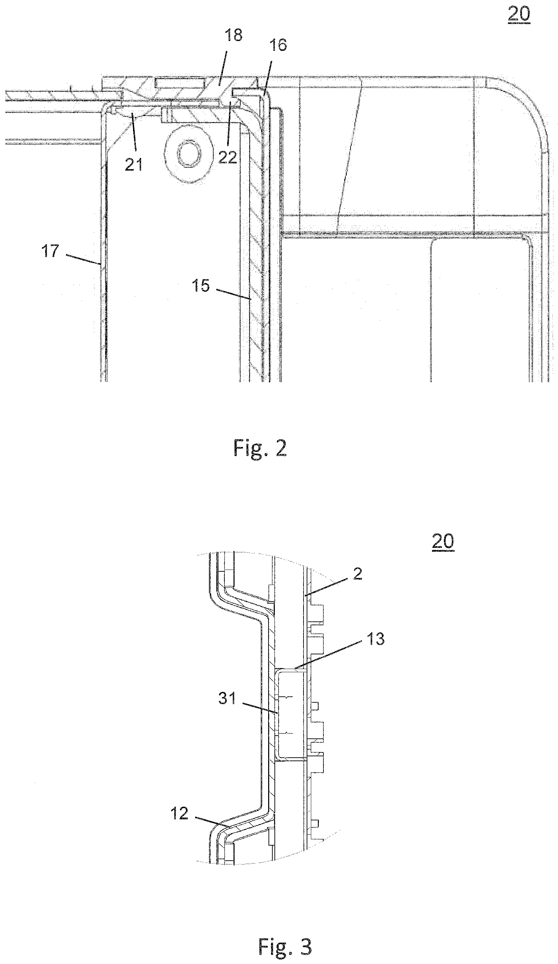

Fig. 2 zeigt eine vergrößerte Darstellung einer Fronthaube 20 bestehend aus der Frontplatte 16 und der Montagewanne 15. Diese Fronthaube 20 ist über eine Rastschiene 18 mit dem Frontrahmenelement 17 verbunden. Dazu ist die Frontplatte 16 durch ein frontseitiges Rastelement 22 der Rastschiene 18 mit der Montagewanne 15 verbunden. Über ein Gehäuse-seitiges Rastelement 21, das unter das Frontrahmenelement 17 mit seiner Nase greift, wird die Fronthaube 20 mit dem Frontrahmenelement 17 verbunden. Seitlich über die Fronthaube 20 ragt der Fronttragegriff 19 hervor, der zum Herausziehen des Messgeräts aus einem Rack Verwendung findet.

Fig. 3 zeigt ein Seitenelement des Kastengehäuses umfassend eine Seitenwand 2, eine Befestigungsschiene 13 sowie eine daran montierte Seitenverkleidung 12. Die Befestigungsschiene 13 besteht vorzugsweise ebenfalls aus einem Edelstahlblech und weist größere Ausnehmungen 31 auf, um Gewicht einzusparen. Die Befestigungsschiene 13 stabilisiert das Kastengehäuse 1 und dient als Befestigungsbasis für die Seitenverkleidung 12 sowie weitere Komponenten wie Tragegriff oder Teleskopschienen.

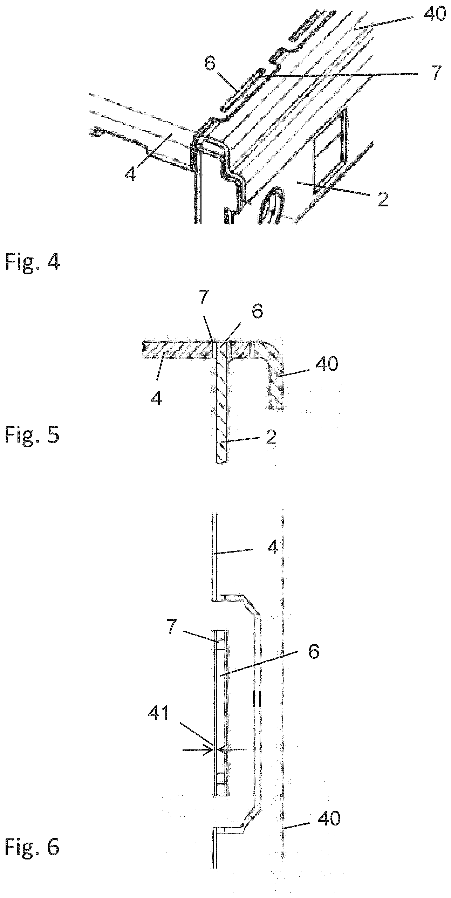

Fig. 4 zeigt einen vergrößerten Ausschnitt der Verbindung zwischen einem deckenseitigen Rahmenelement 4 und einer Seitenwand 2. Das vorzugsweise aus Edelstahlblech hergestellte Rahmenelement 4 weist im Randbereich mindestens eine Ausnehmung 7 auf. Entsprechend ist im Randbereich der Seitenwand 2 integriert in ein Abschlusselement 40 mindestens einen Überstand 6 vorhanden, der zu einer Steckverbindung zusammengefügt ist und durch Schweißen stoffschlüssig mit der Ausnehmung 7 verbunden ist.

In den Figuren 5 und 6 ist diese Steckverbindung in Seitenansicht und in Draufsicht vergrößert dargestellt. Die Seitenwand 2 weist in regelmäßigen Abständen einen Überstand 6 auf, der entsprechend der Stärke des Rahmenelements 4 über die Höhe der Seitenwand 2 übersteht. Der Überstand 6 greift in eine Ausnehmung 7 des deckenseitigen Rahmenelements 4 ein.

Wie in Fig. 6 deutlich zu erkennen, bleibt lediglich ein schmaler Zwischenraum 41 zwischen der Ausnehmung 7 und dem Überstand 6 bestehen. Vorzugsweise werden die Ausnehmungen durch Stanzen oder Laserschneiden hergestellt, sodass der Zwischenraum 41 weniger als 100µm, vorzugsweise weniger als 50µm, Breite misst. Die Seiten- und Trennwände 2,3 sowie die Rahmenelemente 4, 4', 17 lassen sich somit bereits stabil, nur durch Stecken, miteinander verbinden, sodass nunmehr geringe Einspannmaßnahmen für den nachfolgenden Schweißvorgang notwendig sind. Durch den schmalen Zwischenraum 41 verbindet sich sehr schnell das Material des Überstandes mit dem angrenzenden Material des Rahmenelements, sodass der Schweißvorgang schnell und mit geringer Energie ausführbar ist.

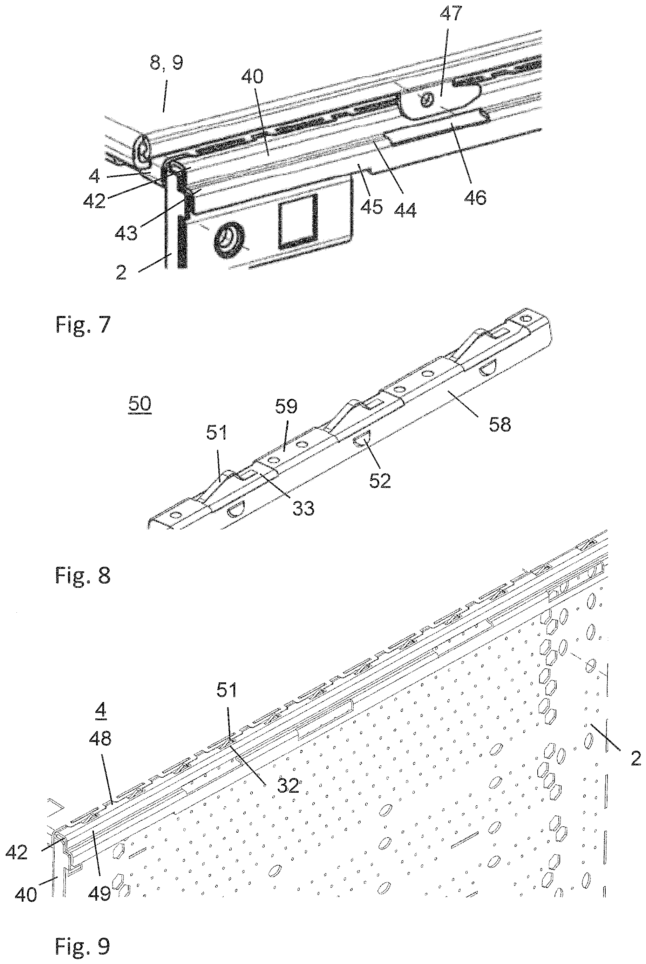

In Fig. 7 ist die Verbindung zwischen einer Seitenwand 2 mit einem flächigen Rahmenelement 4 und insbesondere mit der darüber liegenden Decken- bzw. Bodenplatte 8, 9 dargestellt. Die Seitenwand 2 weist, wie schon in Fig. 4 dargestellt, ein Abschlusselement 40 auf, das zu einem ersten und zweiten Stirnfalz 42, 43 ausgeformt ist. Jeder Stirnfalz 42, 43 weist einen ersten Schenkel 44 und einen zweiten Schenkel 45 auf, der um 90 Grad zum ersten Schenkel 44 gebogen ist. Um die Decken- bzw. Bodenplatte 8, 9 mit geringem Platzbedarf vom Gehäuse lösen zu können, weist die Decken- bzw. Bodenplatte 8, 9 randseitig über ihre Länge verteilt mehrere senkrecht von der Decken- bzw. Bodenplatte 8, 9 überstehende Haken 47 auf, die in Aufnahmeöffnungen 46 im ersten Schenkel 44 des zweiten Stirnfalz 43 eingeschoben werden. Der schräg von der Decken- bzw. Bodenplatte 8, 9 weglaufende Haken sorgt beim Einschieben für eine Vorspannung zwischen Haken 47 und dem ersten Schenkel 44 des Abschlusselementes, sodass die Deckenplatte nicht nur Verrutsch-sicher fixiert ist, sondern auch ein guter elektrischer Kontakt zwischen Seitenwand 2 und Decken- bzw. Bodenplatte 8, 9 gewährleistet ist.

Um den elektrischen Kontakt zwischen Seiten- bzw. Trennwand 2,3 und Decken- bzw. Bodenplatte 8, 9 noch zu verbessern, kann ein erstes Ausführungsbeispiel eines Federbandes 50, siehe Fig. 8, in den ersten Stirnfalz 42 des Abschlusselements 40 der Seiten- bzw. Trennwand 2, 3, wie in Fig. 9 dargestellt, eingebracht werden. Dazu weist der erste Schenkel 48 des ersten Stirnfalzes 42 Ausnehmungen 32 auf, durch die Federzungen 51 des von unten in den ersten Stirnfalz 42 eingeschobenen Federbands 50 hindurchtreten und einen elektrischen Kontakt zur Decken- bzw. Bodenplatte 8, 9 herstellen.

Das in Fig. 8 separat dargestellte Federband 50 wird vorzugsweise aus einem Blechteil hergestellt und weist an einer Stirnseite 59, die zwischen nach unten gebogenen Seitenarmen 58 liegt, Federzungen 51 auf. Die Federzungen 51 sind ebenfalls schmale gebogene Metallstreifen, die an der Stirnseite 59 des Federbandes 50 befestigt sind und in Ausnehmungen 33 in der Stirnseite 59 hineinragen. Das Federband 50 wird durch Halteelemente 52, die beispielsweise durch Einschneiden eines halbkreisförmigen Bogens in die Seitenarme 58 des Federbandes 50 und Hochbiegen des ausgeschnittenen Bereich entstehen, in nicht dargestellten Ausnehmungen in der zweiten Stufe 49 des ersten Stirnfalzes 42 der Seiten- bzw. Trennwand 2,3 vor Verrutschen gesichert.

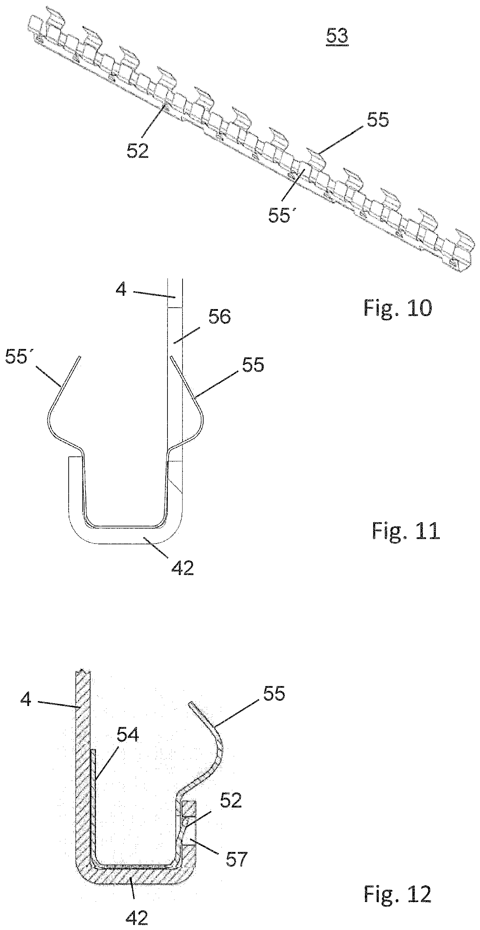

Fig. 10 zeigt ein weiteres Ausführungsbeispiel eines Federbandes 53, das in ähnlicher Weise wie Federband 50 vorzugsweise durch Stanzen und Biegen hergestellt ist. Dieses Federband 53 wird bevorzugt zwischen der Decken- und Bodenplatte 8,9 und dem rückseitigen Rahmenelement 4' bzw. 4 eingesetzt. Das Federband 53 wird ebenfalls über Halteelemente 52 in einem Falz des Rahmenelements 4' bzw. 4 fixiert. Dabei treten die Federelemente 55 in Richtung Decken- bzw. Bodenplatte 8,9 durch Ausnehmungen im Rahmenelement 4, 4' über dieses hervor und bilden einen elektrischen Kontakt zur Decken- bzw. Bodenplatte 8,9. Die in das Innere des Kastengehäuse hineinragenden Federelemente 55' dienen zur elektrischen Kontaktierung eingeschobener Baugruppen bzw. deren Rückwand.

Fig. 11 zeigt das Federband 53 eingebaut in einen Stirnfalz 42 des Rahmenelements 4. Das Federelement 55 tritt durch die Ausnehmung 56 des Rahmenelements 4 hindurch, wohingegen das Federelement 55' zur entgegengesetzten Seite hin weist.

Fig. 12 zeigt ein drittes Ausführungsbeispiel eines Federbands 54, mit einem lediglich nach einer Seite abstehenden Federelement 55. Dieses ist in gleicher Weise wie Federband 53 in Fig. 11 in einen Stirnfalz 42 eines Rahmenelements 4 eingesetzt und wird durch das Halteelement 52 in der Ausnehmung 57 gehalten. Das Halteelement 52 rastet in die Ausnehmung 57 ein und verhindert somit ein Zurückrutschen aus dem Falz heraus. Durch die Breite des Halteelements 52 sowie die Breite der Ausnehmung 57 ist lediglich eine geringe Verschiebung in Längsrichtung des Federbandes 54 möglich.

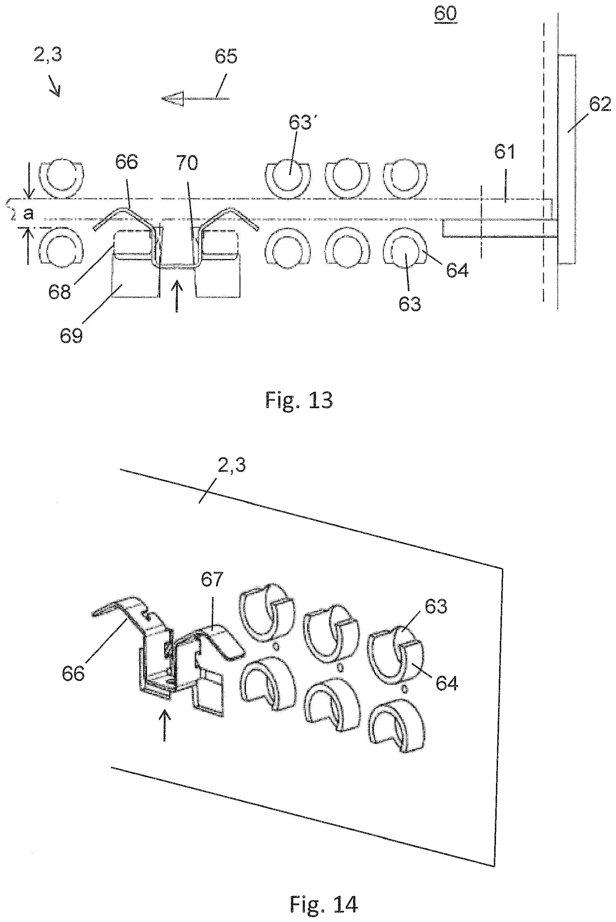

Fig. 13 und Fig. 14 stellt eine Führungsanordnung 60 zum Platzieren von Baugruppen in den Teilbereichen des Kastengehäuses dar. Im Blick auf eine Seiten- oder Trennwand 2, 3 sind Führungsöffnungen 63 erkennbar, die einen Kragen 64 aufweisen. Die Führungsöffnungen 63 sind in zwei Reihen parallel zueinander angeordnet, wobei die Krägen 64 zueinander weisen. Der Abstand a, in Figur 13 links dargestellt, ist dabei so groß, dass Platinen 61 mit unterschiedlicher Stärke zwischen den Krägen eingeschoben werden können. Durch die abgerundete Form, hier zum Beispiel Kreissegmente, der Krägen 64 ist die Platine 61 einer Baugruppe leicht und ohne Beschädigung in Einschubrichtung 65 einschiebbar. Die Platine 61 selbst ist dabei an einer Baugruppenrückwand 62 montiert. Um einen festen Sitz der Platine 61 zwischen den Führungsöffnungen zu gewährleisten, ist eine ohne mehrere Federn 67 in Aufnahmeöffnungen 69 leicht unterhalb der Führungsöffnungen 63 einsetzbar. Die Aufnahmeöffnung 69 weist neben einem großflächigen Bereich einen seitlichen Hals auf, der zusätzlich eine Engstelle 70 aufweist. Halteflügel 68, die seitlich von der Feder abstehen, werden in die Aufnahmeöffnung 69 eingeführt und in Richtung der Platine 61, siehe Pfeil, geschoben. Durch die Engstelle 70 in der Aufnahmeöffnung 69 wird ein Zurückrutschen der Feder 67 verhindert. Lediglich durch Zusammendrücken der Feder 67 kann diese wieder von der Seiten- oder Trennwand 2, 3 entfernt werden.

Die Feder 67 übt auf die Platine einen leichten Anpressdruck aus und hält diese fest an die gegenüber angeordneten Führungsöffnungen 63' an. Somit hat die Platine 61 keinen Bewegungsspielraum mehr bzw. kann bei einem kräftigen Stoß in der Bewegung abgefedert werden.

Die Feder 67 kann bereits vor dem Einschieben der Platine an der Seiten- oder Trennwand 2, 3 montiert sein. Beim Einschieben der Platine 61 in Einschubrichtung 65 wird das nach unten gekrümmte Federelement 66 nach unten gedrückt und lässt die Platine 61 passieren. Der Pfeil in Fig. 14 zeigt die Montagerichtung der Feder 66 an der Seiten- bzw. Trennwand 2, 3. Die Führungsöffnung 63 ist hier in einem auf der gesamten Umfangslänge gleichbleibend hohen Kragen 64 dargestellt. Der Kragen 64 kann jedoch auch auf der von der Platine 61 wegzeigenden Seite niedriger auslaufen. Der Kragen 64 wird bevorzugt durch Ausstanzen bzw. Umbiegen der Seiten- bzw. Trennwand 2,3 hergestellt.

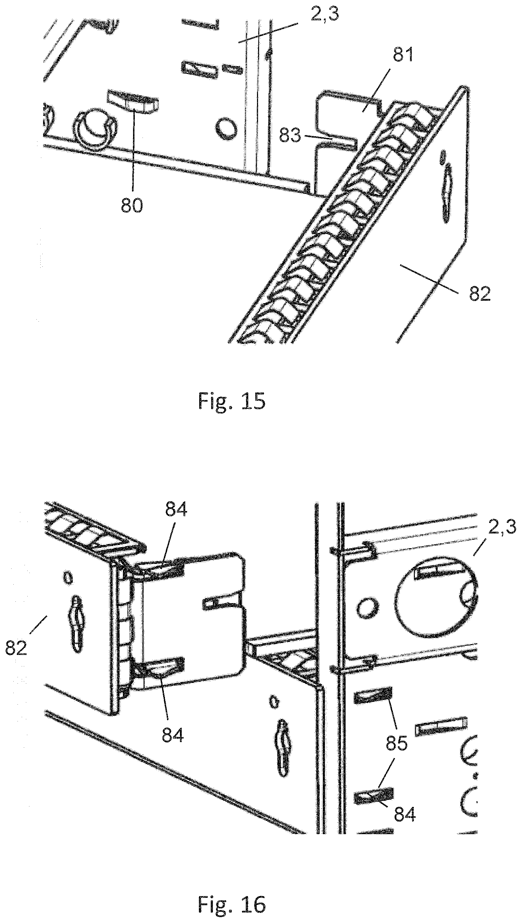

Fig. 15 zeigt eine Zentriernase 80 in einer Seiten- oder Trennwand 2, 3. Die Zentriernase 80 ist in einem geringen Abstand von der Rückseite an der Seiten- bzw. Trennwand 2,3 angeordnet und durch Stanzen und Aufbiegen der Seiten- bzw. Trennwand 2, 3 hergestellt. Eine von der Rückwand 82 einer Baugruppe abstehende Seitenblende 81 weist einen Zentrierschlitz 83 auf, der beim Einschieben der Baugruppe die Zentriernase 80 umschließt. Durch diese Höhenfixierung der Baugruppe kann sichergestellt werden, dass ein Stecker an der Vorderseite der Baugruppe auf passender Höhe mit dem Gegensteckerteil liegt.

In Fig. 16 ist eine weitere Zentrieranordnung, die auch zum Arretieren einer Baugruppe am Gehäuse dient, dargestellt. In dieser Anordnung sind zwei Arretiernasen 84 am oberen und unteren Rand der Seitenblende 81 des Baugruppenrückwand 82 federnd angebracht. Beim Einschieben der Baugruppenrückwand 82 rasten diese Arretiernasen 84 in die entsprechenden Ausnehmungen 85 in der Seiten- bzw. Trennwand 2,3 ein. Da die Arretiernasen 85 entgegen der Einschubrichtung nicht zurückfedern, kann die Baugruppe nur noch mit Hilfsmitteln aus dem Kastengehäuse 1 gelöst werden.

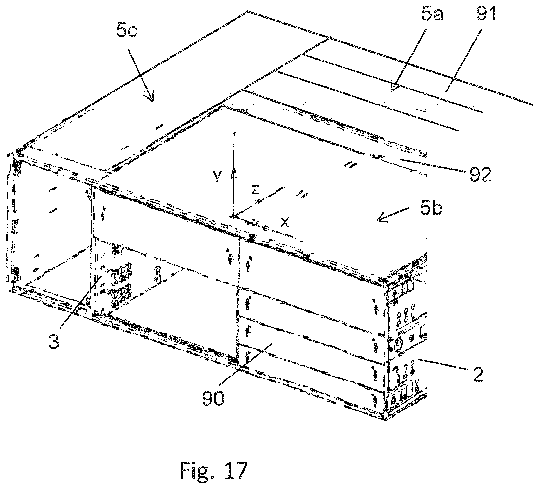

In Fig. 17 ist ein Kastengehäuse 1 mit den Teilbereichen 5a, 5b und 5c dargestellt. Im Teilbereich 5b sind mehrere erste Baugruppen 90 in z-Richtung eingeschoben. Im Bereich 92 befindet sich ein erstes Grundrechnermodul, das in y-Richtung ausgerichtet ist. Die ersten Baugruppen 90 sind über Stecker mit dem ersten Grundrechnermodul verbunden. Im Teilbereich 5a sind Steckplätze für zweite Baugruppen 91 dargestellt, die ebenfalls in y-Richtung eingeschoben werden und über Stecker in ein in z-Richtung am Boden des Teilbereichs angeordnetes zweites Grundrechnermodul, nicht dargestellt, eingesteckt werden. Die beiden Grundrechnermodule sind vorzugsweise ebenfalls durch Stecker miteinander verbunden.

Durch diese Einbaurichtung der ersten bzw. zweiten Baugruppe 90, 91 kann in x-Richtung sowohl zwischen den ersten Baugruppen 90 als auch den zweiten Baugruppen 91 ein Luftstrom hindurchtreten. Die in y-Richtung orientierten Seitenwände 2 und Trennwände 3 weisen eine Vielzahl von Öffnungen wie zum Beispiel die Führungsöffnungen 63 aber auch dedizierte Lüftungsöffnungen auf, sodass Luft in x-Richtung ein- bzw. ausströmen kann. Diese Anordnung ermöglicht somit eine effektive Belüftung der ersten sowie der zweiten Baugruppe sowie ihrer zugeordneten Grundrechnermodule.

Wird das Kastengehäuse beispielsweise für ein Hochfrequenzmessgerät verwendet, können digitale Baugruppen als erste Baugruppen 90 in Teilbereich 5b und analoge Schaltungen für die HF-Erzeugung bzw. Analyse als zweiten Baugruppen 91 in Teilbereich 5a untergebracht sein. Im Teilbereich 5c des Kastengehäuses 1 kann sich die Stromversorgungsbaugruppe des Geräts befinden.

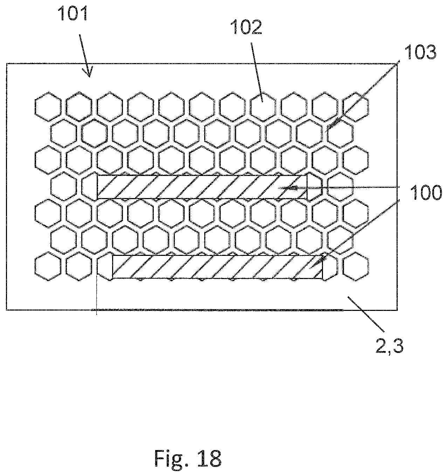

Fig. 18 zeigt eine Lüftungszone 101 einer Seiten- bzw. Trennwand 2, 3. Eine Vielzahl von Lüftungsöffnungen 102 sind dicht nebeneinander angeordnet und lediglich durch schmale Steg 103 voneinander getrennt. Die Lüftungsöffnungen 102 werden wie die meisten bisher beschriebenen Öffnungen oder Ausnehmungen durch Stanzen in das Edelstahlblech eingebracht. Um ein Aufwellen der Seiten- bzw. Trennwand 2, 3 zu vermeiden, wird eine Querprägung, das heißt senkrecht zur Ebene der Seiten- bzw. Trennwand, in diese eingebracht. Ein Prägestempel 100 wird dazu auf einen Teilbereich der Lüftungszone 101, die bevorzugt 8 Lüftungsöffnungen 102 umfasst, aufgesetzt. Diese Querprägung ist bevorzugt ca. 0,4 mm tief und wiederholt sich bevorzugt in jeder vierten Reihe der Lüftungsöffnungen 102.

## Patentansprüche

1. Kastengehäuse zum Einbau von elektronischen Baugruppen (90, 91) mit Seitenwänden (2), das eine Unterteilung in Teilbereiche (5a, 5b, 5c), die durch Trennwände (3, 3') begrenzt sind, aufweist,
wobei das Kastengehäuse Rahmenelemente (4, 4', 17) aufweist, wobei die Rahmenelemente (4, 4', 17) mindestens eine Ausnehmung (7) aufweisen,
wobei die Seitenwände (2) und/oder die Trennwände (3, 3') mindestens einen randseitigen Überstand (6) aufweisen,
wobei der Überstand (6) in eine Ausnehmung (7) eingreift und der Überstand (6) und die Ausnehmung (7) durch Schweißen miteinander verbunden sind,
wobei eine Deckplatte und/oder eine Bodenplatte (8, 9) randseitig senkrecht von der Deckplatte bzw. Bodenplatte (9) überstehende Haken (47) aufweist, die durch Einschieben der Haken (47) in Aufnahmeöffnungen (46) in den Seitenwänden (2) und/oder Trennwänden (3) mit den Seitenwänden (2) und/oder Trennwänden (3) verbunden ist,
wobei jede Seiten- und/oder Trennwand (2, 3) mindestens ein Abschlusselement (40) aufweist, das zu einem ersten Stirnfalz (42) mit einem ersten (48) und zweiten (49) zueinander geneigten Schenkel und einem zweiten Stirnfalz (43) mit einem ersten (44) und zweiten (45) zueinander geneigten Schenkel ausgeformt ist,
wobei der zweite Stirnfalz (43) im ersten Schenkel (44) die Aufnahmeöffnungen (46) für die Deck- bzw. Bodenplatte (8, 9) aufweist,
wobei ein Federband (50) zur elektrischen Kontaktierung zwischen Seiten- bzw. Trennwand (2, 3) und Decken- bzw. Bodenplatte (8, 9) in den ersten Stirnfalz (42) der Seiten- und/oder Trennwand (2, 3) eingebracht ist.

2. Kastengehäuse nach Anspruch 1,
**dadurch gekennzeichnet,**
**dass** zwischen dem Überstand (6) und einem Rand der Ausnehmung (7), in die der Überstand (6) eingreift, ein Zwischenraum (41) von weniger als 100µm Breite, bevorzugt weniger als 50µm Breite, gebildet ist.

3. Kastengehäuse nach Anspruch 1,
**dadurch gekennzeichnet,**
**dass** das Federband (50, 53, 54) in mehrere Aufnahmeöffnungen an dem zweiten Schenkel (45, 49) des Stirnfalzes (42, 43) gehalten ist.

4. Kastengehäuse nach einem der Ansprüche 1 bis 3,
**dadurch gekennzeichnet,**
**dass** eine Seiten- und/oder eine Trennwand (2, 3) mehrere Führungsöffnungen (63) mit überstehenden Kragen (64) aufweist, wobei die Führungsöffnungen (63) auf zwei parallelen Geraden in einem Abstand (a) voneinander, parallel zur Einschubrichtung (65) einer elektronischen Baugruppe (90, 91) an der Seiten- und/oder Trennwand (2, 3) angeordnet sind.

5. Kastengehäuse nach Anspruch 4,
**dadurch gekennzeichnet,**
**dass** der Kragen (64) einer Führungsöffnung (63) eine runde Kontur aufweist.

6. Kastengehäuse nach Anspruch 4 oder 5,
**dadurch gekennzeichnet,**
**dass** der Kragen (64) einstückig mit der Seiten- und/oder Trennwand (2, 3) ausgeführt ist.

7. Kastengehäuse nach einem der Ansprüche 4 bis 6,
**dadurch gekennzeichnet,**
**dass** mindestens ein Federelement (66) mit einer Seiten- und/oder Trennwand (2, 3) lösbar verbunden und so angeordnet ist, dass es in den durch die beabstandeten Führungsöffnungen (63, 63') begrenzten Bereich hineinragt.

8. Kastengehäuse nach Anspruch 7,
**dadurch gekennzeichnet,**
**dass** das Federelement (66) an einer Ausnehmung (69) der Seiten- und/oder Trennwand (2, 3) lösbar gehalten ist.

9. Kastengehäuse nach einem der Ansprüche 1 bis 8,
**dadurch gekennzeichnet,**
**dass** mindestens eine Zentrierungsnase (80, 84) im Randbereich der Seiten- und/oder Trennwand (2, 3) angeordnet ist, in die eine Ausnehmung (83, 85) eines Baugruppengehäuses eingreift.

10. Kastengehäuse nach einem der Ansprüche 1 bis 9,
**dadurch gekennzeichnet,**
**dass** in einem ersten Teilbereich (5a, 5b, 5c) eine erste Baugruppe (90) oder mehrere erste Baugruppen (90) senkrecht zur Ebene einer Seitenwand (2) eingebaut sind und in einem zweiten Teilbereich (5a, 5b, 5c) eine zweite Baugruppe (91) oder mehrere zweite Baugruppen (91) senkrecht zur Seitenwand (2) und senkrecht zu der ersten Baugruppe (90) im ersten Teilbereich (5a, 5b, 5c) eingebaut sind.

11. Kastengehäuse nach Anspruch 10,
**dadurch gekennzeichnet,**
**dass** die eine erste Baugruppe (90) oder mehrere erste Baugruppen (90) in ein erstes Grundrechnermodul eingesteckt ist bzw. sind,
**dass** die eine zweite Baugruppe (91) oder mehrere zweite Baugruppen (91) in ein zweites Grundrechnermodul eingesteckt ist bzw. sind und
**dass** das erste Grundrechnermodul parallel zur Steckrichtung der zweiten Baugruppe (91) sowie das zweite Grundrechnermodul parallel zur Steckrichtung der ersten Baugruppe (90) angeordnet ist.

12. Kastengehäuse nach Anspruch 11,
**dadurch gekennzeichnet,**
**dass** das erste Grundrechnermodul und das zweite Grundrechnermodul durch eine Steckverbindung miteinander verbunden sind.

13. Kastengehäuse nach einem der Ansprüche 1 bis 12,
**dadurch gekennzeichnet,**
**dass** zumindest eine Seiten- und/oder Trennwand (2, 3) eine oder mehrere Lüftungszonen (101) mit jeweils einer Vielzahl von Lüftungsöffnungen (102) aufweist und ein Luftstrom parallel zur ersten Baugruppe (90) und parallel zur zweiten Baugruppe (91) durch die Lüftungszonen (101) ein- bzw. ausblasbar ist.

14. Kastengehäuse nach einem der Ansprüche 1 bis 13,
**dadurch gekennzeichnet,**
**dass** das Rahmenelemente (4, 4', 17), die Seiten- und/oder Trennwand (2, 3) und/oder die Deck- und Bodenplatte (8, 9) aus rostfreiem Edelstahl besteht bzw. bestehen.

15. Verfahren zur Herstellung eines Kastengehäuses zum Einbau von elektronischen Baugruppen (90, 91), wobei das Kastengehäuse (1) Seitenwände (2) und eine Unterteilung in Teilbereiche (5a, 5b, 5c), die durch Trennwände (3) begrenzt sind, aufweist,
wobei mindestens eine Ausnehmung (7) und/oder mindestens ein randseitiger Überstand (6) in die Rahmenelemente (4, 4', 17) und/oder Seiten- und/oder Trennwänden (2, 3) eingebracht werden,
wobei die Rahmenelemente (4, 4', 17) und die Seitenwände (2) und Trennwände (3) zusammengefügt werden, indem jeweils ein Überstand (6) in eine Ausnehmung (7) eingreift und jeder Überstand (6) und jede Ausnehmung (7) durch Schweißen miteinander verbunden werden,
wobei eine Deckplatte und/oder eine Bodenplatte (8, 9) randseitig senkrecht von der Deckplatte bzw. Bodenplatte (9) überstehende Haken (47) aufweist, wobei die Haken (47) in Aufnahmeöffnungen (46) in den Seitenwänden (2) und/oder Trennwänden (3) in Eingriff gebracht werden,
wobei jede Seiten- und/oder Trennwand (2, 3) mindestens ein Abschlusselement (40) aufweist, das zu einem ersten Stirnfalz (42) mit einem ersten (48) und zweiten (49) zueinander geneigten Schenkel und einem zweiten Stirnfalz (43) mit einem ersten (44) und zweiten (45) zueinander geneigten Schenkel ausgeformt wird,
wobei der zweite Stirnfalz (43) im ersten Schenkel (44) die Aufnahmeöffnungen (46) für die Deck- bzw. Bodenplatte (8, 9) aufweist,
wobei ein Federband (50) zur elektrischen Kontaktierung zwischen Seiten- bzw. Trennwand (2, 3) und Decken- bzw. Bodenplatte (8, 9) in den ersten Stirnfalz (42) der Seiten- und/oder Trennwand (2, 3) eingebracht wird.

16. Verfahren nach Anspruch 15,
**dadurch gekennzeichnet,**
**dass** in die Seiten- und/oder Trennwand (2, 3) eine oder mehrere Lüftungszonen (101) mit jeweils einer Vielzahl von Lüftungsöffnungen (102) eingebracht werden und im Bereich der Lüftungszone (101) eine Querprägung in die Seiten- und/oder Trennwand (2, 3) eingebracht wird.

17. Verfahren nach Anspruch 15 oder 16,
**dadurch gekennzeichnet,**
**dass** alle Ausnehmungen (6), Überstände (7), Aufnahme-, Führungs- und Lüftungsöffnungen (63, 102) mittels Stanzen eingebracht werden und die Führungsnasen (80) mittels Prägen eingebracht werden.

## Claims

1. Box enclosure for installation of electronic assemblies (90, 91) with side walls (2), which has a subdivision into part regions (5a, 5b, 5c) which are bounded by partition walls (3, 3'),
wherein the box enclosure has frame elements (4, 4', 17), the frame elements (4, 4', 17) having at least one recess (7).
wherein the side walls (2) and/or the partition walls (3, 3') have at least one projection (6) at the edge, wherein the projection (6) engages in a recess (7) and the projection (6) and the recess (7) are connected with one another by welding,
wherein a cover plate and/or a bottom plate (8, 9) have hooks (47) which project perpendicularly from the cover plate or bottom plate (9) at the edge and are connected with the side walls (2) and/or partition walls (3) by sliding the hooks (47) into receiving openings (46) in the side walls (2) and/or partition walls (3),
wherein each side and/or partition wall (2, 3) has at least one closing element (40) which is shaped to form a first front channel moulding (42) with a first limb (48) and a second limb (49) inclined at an angle to one another and a second front channel moulding (43) with a first limb (44) and a second limb (45) inclined at an angle to one another,
wherein the second front channel moulding (43) has the receiving openings (46) for the cover plate and bottom plate (8, 9) in the first limb (44),
wherein a spring strip (50) is fitted into the first front channel moulding (42) of the side and/or partition wall (2, 3) to ensure electrical contact between the side or partition wall (2, 3) and the cover or bottom plate (8, 9).

2. Box enclosure according to claim 1,
**characterised in that**
a space (41) of less than 100 µm wide, preferably less than 50 µm wide, is formed between the projection (6) and one edge of the recess (7) in which the projection (6) engages.

3. Box enclosure according to claim 1,
**characterised in that**
the spring strip (50, 53, 54) is held in a plurality of receiving openings in the second limb (45, 49) of the front channel moulding (42, 43).

4. Box enclosure according to one of claims 1 to 3,
**characterised in that**
a side and/or a partition wall (2, 3) has a plurality of guide openings (63) with projecting collars (64), the guide openings (63) being arranged on the side and/or partition wall (2, 3) on two parallel straight lines at a distance (a) from one another, parallel to the direction of insertion (65) of an electronic assembly (90, 91).

5. Box enclosure according to claim 4,
**characterised in that**
the collar (64) of a guide opening (63) has a round contour.

6. Box enclosure according to claim 4 or 5,
**characterised in that**
the collar (64) is formed in one piece with the side and/or partition wall (2, 3).

7. Box enclosure according to one of claims 4 to 6,
**characterised in that**
at least one spring element (66) is detachably connected with a side and/or partition wall (2, 3) and arranged so that it projects into the region bounded by the spaced guide openings (63, 63').

8. Box enclosure according to claim 7,
**characterised in that**
the spring element (66) is detachably held in a recess (69) of the side and/or partition wall (2, 3).

9. Box enclosure according to one of claims 1 to 8,
**characterised in that**
at least one centring lug (80, 84) is arranged in the edge region of the side and/or partition wall (2, 3) in which a recess (83, 85) of an assembly housing engages.

10. Box enclosure according to one of claims 1 to 9,
**characterised in that**
a first assembly (90) or a plurality of first assemblies (90) are installed in a first part region (5a, 5b, 5c) perpendicularly to the plane of a side wall (2) and a second assembly (91) or a plurality of second assemblies (91) are installed in a second part region (5a, 5b, 5c) perpendicularly to the side wall (2) and perpendicularly to the first assembly (90) in the first part region (5a, 5b, 5c).

11. Box enclosure according to claim 10,
**characterised in that**
the one first assembly (90) or plurality of first assemblies (90) is/are plugged into a first basic computer module,
**in that** the one second assembly (91) or plurality of second assemblies (91) is/are plugged into a second basic computer module and
**in that** the first basic computer module is arranged parallel to the direction in which the second assembly (91) is plugged and the second basic computer module is arranged parallel to the direction in which the first assembly (90) is plugged.

12. Box enclosure according to claim 11,
**characterised in that**
the first basic computer module and the second basic computer module are connected with one another by a plug-type connection.

13. Box enclosure according to one of claims 1 to 12,
**characterised in that**
at least one side and/or partition wall (2, 3) has one or more ventilation zones (101) each with a plurality of ventilation openings (102) and a stream of air can be blown in or out through the ventilation zones (101) parallel to the first assembly (90) and parallel to the second assembly (91).

14. Box enclosure according to one of claims 1 to 13,
**characterised in that**
the frame elements (4, 4', 17), the side and/or partition wall (2, 3) and/or the cover plate and bottom plate (8, 9) are made of stainless steel.

15. Method for production of a box enclosure for installation of electronic assemblies (90, 91) wherein the box enclosure (1) has side walls (2) and a subdivision into part regions (5a, 5b, 5c) which are bounded by partition walls (3),
wherein at least one recess (7) and/or at least one projection (6) at the edge are formed in the frame elements (4, 4', 17) and/or side and/or partition walls (2, 3),
wherein the frame elements (4, 4', 17) and the side walls (2) and partition walls (3) are assembled together in that in each case a projection (6) engages in a recess (7) and each projection (6) and each recess (7) are connected together by welding,
wherein a cover plate and/or a bottom plate (8, 9) have hooks (47) which project perpendicularly from the cover plate or bottom plate (9) at the edge, the hooks (47) being brought into engagement in receiving openings (46) in the side walls (2) and/or partition walls (3),
wherein each side and/or partition wall (2, 3) has at least one closing element (40) which is shaped to form a first front channel moulding (42) with a first limb (48) and a second limb (49) inclined at an angle to one another and a second front channel moulding (43) with a first limb (44) and a second limb (45) inclined at an angle to one another,
wherein the second front channel moulding (43) has the receiving openings (46) for the cover plate and bottom plate (8, 9) in the first limb (44),
wherein a spring strip (50) is fitted into the first front channel moulding (42) of the side and/or partition wall (2, 3) to ensure electrical contact between the side or partition wall (2, 3) and the cover or bottom plate (8, 9).

16. Method according to claim 15,
**characterised in that**
one or more ventilation zones (101) each with a multiplicity of ventilation openings (102) are formed in the side and/or partition wall (2, 3), and a transverse embossed impression is formed in the side and/or partition wall (2, 3) in the region of the ventilation zone (101).

17. Method according to claim 15 or 16,
**characterised in that**
all the recesses (6), projections (7), receiving, guide and ventilation openings (63, 102) are formed by means of punching and the guide lugs (80) are formed by means of embossing.

## Revendications

1. Boitier en forme de coffret destiné au montage de modules électroniques (90, 91), comprenant des parois latérales (2), et qui présente une subdivision en zones partielles (5a, 5b, 5c) délimitées par des parois de séparation (3, 3'),
boitier en forme de coffret
dans lequel sont prévus des éléments de châssis (4, 4', 17), et les éléments de châssis (4, 4', 17) présentent au moins un évidement (7),
dans lequel les parois latérales (2) et/ou les parois de séparation (3, 3') présentent sur le bord, au moins une saillie de bordure (6),
dans lequel la saillie de bordure (6) vient en prise dans un évidement (7), et la saillie de bordure (6) et l'évidement (7) sont reliés mutuellement par soudage, dans lequel une plaque de couvercle et/ou une plaque de fond (8,9) présente en bordure, des crochets (47), qui font saillie perpendiculairement de la plaque de couvercle ou respectivement de la plaque de fond (9), et sont reliés aux parois latérales (2) et/ou aux parois de séparation (3), par insertion des crochets (47) dans des ouvertures d'accueil (46) des parois latérales (2) et/ou des parois de séparation (3),
dans lequel chaque paroi latérale et/ou de séparation (2, 3) présente au moins un élément terminal (40), qui est formé en une première feuillure frontale de pliage (42) avec une première aile (48) et une deuxième aile (49) inclinées l'une par rapport à l'autre, et en une deuxième feuillure frontale de pliage (43) avec une première aile (44) et une deuxième aile (45) inclinées l'une par rapport à l'autre,
dans lequel la deuxième feuillure frontale de pliage (43) présente, dans la première aile (44), les ouvertures d'accueil (46) pour la plaque de couvercle et respectivement la plaque de fond (8, 9),
et dans lequel une bande de ressort (50), pour assurer le contact électrique entre la paroi latérale ou respectivement de séparation (2, 3) et la plaque de couvercle et respectivement de fond (8, 9), est insérée dans la première feuillure frontale de pliage (42) de la paroi latérale et/ou de séparation (2, 3).

2. Boitier en forme de coffret selon la revendication 1,
**caractérisé**
**en ce qu'**entre la saillie de bordure (6) et un bord de l'évidement (7) dans lequel s'engage la saillie de bordure (6), est formé un espace intermédiaire (41) d'une largeur de moins de 100µm, de préférence d'une largeur de moins de 50µm.

3. Boitier en forme de coffret selon la revendication 1,
**caractérisé**
**en ce que** la bande de ressort (50, 53, 54) est maintenue dans plusieurs ouvertures d'accueil sur la deuxième aile (45, 49) de la feuillure frontale de pliage (42, 43).

4. Boitier en forme de coffret selon l'une des revendications 1 à 3,
**caractérisé**
**en ce qu'**une paroi latérale et/ou de séparation (2, 3) présente plusieurs ouvertures de guidage (63) avec des collerettes (64) en saillie, les ouvertures de guidage (63) étant agencées sur deux droites parallèles, à une distance d'espacement (a) l'une de l'autre, parallèlement à une direction d'insertion (65) d'un module électronique (90, 91), sur la paroi latérale et/ou de séparation (2, 3).

5. Boitier en forme de coffret selon la revendication 4,
**caractérisé**
**en ce que** la collerette (64) d'une ouverture de guidage (63) présente un contour rond.

6. Boitier en forme de coffret selon la revendication 4 ou la revendication 5,
**caractérisé**
**en ce que** la collerette (64) est réalisée d'un seul tenant avec la paroi latérale et/ou de séparation (2, 3).

7. Boitier en forme de coffret selon l'une des revendications 4 à 6,
**caractérisé**
**en ce qu'**au moins un élément de ressort (66) est relié de manière amovible à une paroi latérale et/ou de séparation (2, 3), et est agencé de manière à s'engager dans la zone délimitée par les ouvertures de guidage (63, 63') espacées.

8. Boitier en forme de coffret selon la revendication 7,
**caractérisé**
**en ce que** l'élément de ressort (66) est maintenu de manière amovible dans un évidement (69) de la paroi latérale et/ou de séparation (2, 3).

9. Boitier en forme de coffret selon l'une des revendications 1 à 8,
**caractérisé**
**en ce qu'**au moins un talon de centrage (80, 84) est agencé dans la zone de bordure de la paroi latérale et/ou de séparation (2, 3), et sur celui-ci vient s'engager un évidement (83, 85) d'un boitier de module.

10. Boitier en forme de coffret selon l'une des revendications 1 à 9,
**caractérisé**
**en ce que** dans une première zone partielle (5a, 5b, 5c) sont montés un premier module (90) ou plusieurs premiers modules (90), perpendiculairement au plan d'une paroi latérale (2), et dans une deuxième zone partielle (5a, 5b, 5c) sont montés un deuxième module (91) ou plusieurs deuxièmes modules (91), perpendiculairement à la paroi latérale (2) et perpendiculairement au premier module (90) dans la première zone partielle (5a, 5b, 5c).

11. Boitier en forme de coffret selon la revendication 10,
**caractérisé**
**en ce que** ledit un premier module (90) ou plusieurs premiers modules (90) est ou sont enfichés dans un premier module de calculateur de base,
**en ce que** ledit un deuxième module (91) ou plusieurs deuxièmes modules (91) est ou sont enfichés dans un deuxième module de calculateur de base, et
**en ce que** le premier module de calculateur de base est agencé parallèlement à la direction selon laquelle est enfiché le deuxième module (91), et le deuxième module de calculateur de base est agencé parallèlement à la direction selon laquelle est enfiché le premier module (90).

12. Boitier en forme de coffret selon la revendication 11,
**caractérisé**
**en ce que** le premier module de calculateur de base et le deuxième module de calculateur de base sont reliés mutuellement par l'intermédiaire d'une connexion enfichable.

13. Boitier en forme de coffret selon l'une des revendications 1 à 12,
**caractérisé**
**en ce qu'**au moins une paroi latérale et/ou de séparation (2, 3) présente une ou plusieurs zones de ventilation (101) avec chacune un grand nombre d'ouvertures de ventilation (102), et un flux d'air peut être insufflé et respectivement soufflé, parallèlement au premier module (90) et parallèlement au deuxième module (91), à travers les zones de ventilation (101).

14. Boitier en forme de coffret selon l'une des revendications 1 à 13,
**caractérisé**
**en ce que** les éléments de châssis (4, 4', 17), les parois latérales et/ou de séparation (2, 3) et/ou la plaque de couvercle et de fond (8, 9) est ou sont réalisés en un acier surfin inoxydable.

15. Procédé de fabrication d'un boitier en forme de coffret destiné au montage de modules électroniques (90, 91), le boitier en forme de coffret (1) présentant des parois latérales (2) et une subdivision en zones partielles (5a, 5b, 5c), qui sont délimitées par des parois de séparation (3), procédé,
d'après lequel on réalise au moins un évidement (7) et/ou au moins une saillie de bordure (6) au bord des éléments de châssis (4, 4', 17) et/ou des parois latérales et/ou de séparation (2, 3),
d'après lequel on assemble les éléments de châssis (4, 4', 17) et les parois latérales (2) et de séparation (3), en insérant respectivement une saillie de bordure (6) dans un évidement (7), et en reliant chaque saillie de bordure (6) et chaque évidement (7), par soudage,
d'après lequel une plaque de couvercle et/ou une plaque de fond (8, 9) présente, en bordure, des crochets (47), qui font saillie perpendiculairement de la plaque de couvercle ou respectivement de la plaque de fond (9), les crochets (47) étant amenés en prise dans des ouvertures d'accueil (46) des parois latérales (2) et/ou des parois de séparation (3),
d'après lequel chaque paroi latérale et/ou de séparation (2, 3) présente au moins un élément terminal (40), que l'on forme en une première feuillure frontale de pliage (42) avec une première aile (48) et une deuxième aile (49) inclinées l'une par rapport à l'autre, et en une deuxième feuillure frontale de pliage (43) avec une première aile (44) et une deuxième aile (45) inclinées l'une par rapport à l'autre,
d'après lequel la deuxième feuillure frontale de pliage (43) présente, dans la première aile (44), les ouvertures d'accueil (46) pour la plaque de couvercle et respectivement la plaque de fond (8, 9), et
d'après lequel on insère une bande de ressort (50), pour assurer le contact électrique entre la paroi latérale ou respectivement de séparation (2, 3) et la plaque de couvercle et respectivement de fond (8, 9), dans la première feuillure frontale de pliage (42) de la paroi latérale et/ou de séparation (2, 3).

16. Procédé selon la revendication 15,
**caractérisé**
**en ce que** l'on réalise dans la paroi latérale et/ou de séparation (2, 3), une ou plusieurs zones de ventilation (101) avec un grand nombre d'ouvertures de ventilation (102), et l'on réalise dans la zone de ventilation (101), un nervurage transversal de matriçage dans la paroi latérale et/ou de séparation (2, 3).

17. Procédé selon la revendication 15 ou la revendication 16,
**caractérisé**
**en ce que** tous les évidements (7), toutes les saillies de bordure (6), toutes les ouvertures d'accueil, de guidage et de ventilation (63, 102) sont réalisés par découpage par poinçonnage, et les talons de guidage (80) sont réalisés par matriçage de formage.
